Europäisches Patentamt

(19) European Patent Office

Office européen des brevets

(11) Numéro de publication: **0 125 947**

**A1**

(12) **DEMANDE DE BREVET EUROPEEN**

(21) Numéro de dépôt: 84400704.7

(22) Date de dépôt: 10.04.84

(51) Int. Cl.³: **H 03 K 4/50**

(30) Priorité: 15.04.83 FR 8306222

(43) Date de publication de la demande:
21.11.84 Bulletin 84/47

(84) Etats contractants désignés:
DE GB SE

(71) Demandeur: **THOMSON-CSF**
**173, Boulevard Haussmann**
**F-75379 Paris Cedex 08(FR)**

(72) Inventeur: **Lambert, Jean-Alphonse**
**THOMSON-CSF SCPI 173, bld Haussmann**
**F-75379 Paris Cedex 08(FR)**

(72) Inventeur: **Voisin, Gérard**
**THOMSON-CSF SCPI 173, bld Haussmann**
**F-75379 Paris Cedex 08(FR)**

(74) Mandataire: **Trocellier, Roger et al,**
**THOMSON-CSF SCPI 173, Bld Haussmann**
**F-75379 Paris Cedex 08(FR)**

(54) Circuit générateur de dents de scie, en particulier, pour balayage cathodique ligne par ligne.

㊗ Le circuit générateur de dents de scie comprend un circuit intégrateur (1) commandé par un interrupteur (I1), délivrant un signal en dents de scie (V1) et alimenté par un circuit générateur (2). Un signal de décalage (V3) fourni par un deuxième circuit générateur (3) s'ajoute au signal (V1) par l'intermédiaire d'un sommateur (5) pour caler la valeur moyenne du signal (V1) à une valeur déterminée. Les deux générateurs (2) et (3) comportent une alimentation stabilisée (Vcc) réglable (P2, P3) et une boucle d'asservissement qui se compose d'un interrupteur (I2, I3) suivi d'un intégrateur différentiel (6, 7). Le réglage de l'amplitude et le calage de la valeur moyenne des dents de scie sont asservis et réglables indépendamment l'un de l'autre. Un générateur d'impulsions (4) commande l'interrupteur (I1) de l'intégrateur en opposition avec les interrupteurs (I2, I3) des boucles.

Application aux circuits de balayage d'une caméra de télévision.

FIG_1

1

# CIRCUIT GENERATEUR DE DENTS DE SCIE, EN PARTICULIER, POUR BALAYAGE CATHODIQUE LIGNE PAR LIGNE

La présente invention concerne un circuit générateur de dents de scie permettant notamment de produire un balayage cathodique ligne par ligne. L'invention s'applique avantageusement à réaliser des circuits de balayage d'une caméra de prise de vue de télévision.

Il est connu de réaliser différents montages intégrateurs utilisant une cellule résistance-condensateur ou le montage d'un amplificateur opérationnel avec un condensateur et en dérivation sur ce dernier un interrupteur. Le signal en dents de scie est produit par la charge continue du condensateur commandé périodiquement à la décharge par fermeture de l'interrupteur. Suivant une de ces solutions décrites dans le document de brevet français FR-A-2 441 964 le circuit générateur de dents de scie comporte une boucle d'asservissement de la valeur moyenne de la dent de scie à une valeur de calage prédéterminée pour compenser les variations d'amplitude du signal de sortie dues notamment à des variations de température et pour préserver le centrage du signal sur cette valeur de calage. En outre, le circuit peut être doté de moyens de réglage pour faire varier l'amplitude des dents de scie. La boucle se compose d'un interrupteur suivi d'un filtre passe-bas pour filtrer le continu et un montage amplificateur pour conférer à la boucle un gain déterminé.

Un tel circuit ne permet pas le réglage de l'amplitude indépendamment de celui du calage de la valeur moyenne de la dent de scie. Le changement d'un seul de ces deux paramètres nécessite la modification de deux tensions continues stabilisées utilisées pour alimenter l'intégrateur.

Le but de l'invention est de remédier aux inconvénients précités en rendant indépendant le réglage et l'asservissement de l'amplitude, et le réglage et l'asservissement de la valeur moyenne des dents de scie. Selon une utilisation envisagée on alimente les éléments déviateurs électromagnétiques d'un tube cathodique d'une caméra ou d'un moniteur de télévision en assurant la stabilité de l'amplitude du signal et du cadrage du point milieu de l'écran balayé, et ceci malgré de fréquentes et fortes variations de température.

Un objet de l'invention est d'utiliser deux boucles d'asservissement indépendantes pour permettre un réglage de la valeur moyenne indépendant de celui de l'amplitude de la dent de scie.

Suivant l'invention, il est proposé de réaliser un circuit générateur de dents de scie comportant un circuit intégrateur, un circuit générateur de signal à intégrer pour alimenter l'intégrateur et qui est doté de moyens de réglage de l'amplitude des dents de scie du signal issu du circuit intégrateur à une valeur d'amplitude déterminée, un circuit générateur d'impulsion pour la commande périodique de l'intégrateur, et une première boucle d'asservissement pour asservir la valeur moyenne des dents de scie à un potentiel de calage désiré, la première boucle recevant le signal de sortie en dents de scie, caractérisé en ce que le circuit générateur de signal à intégrer comporte une deuxième boucle d'asservissement pour asservir l'amplitude de la dent de scie à ladite valeur déterminée, la sortie du circuit intégrateur étant appliquée à l'entrée de la deuxième boucle ainsi qu'à une première entrée d'un circuit sommateur qui reçoit par une deuxième entrer la sortie de la première boucle, le sommateur délivrant le signal de sortie en dents de scie.

L'invention, ses particularités et avantages seront mieux compris à la lecture de la description qui suit, donnée à titre d'exemple non limitatif, et illustrée par les figures suivantes :

   - Fig.1, représentant un diagramme général d'un ciruit générateur de dents de scie conforme à l'invention ;

   - Fig.2A à 2D, représentant des courbes et des formes de signaux relatives au fonctionnement du circuit selon la figure 1 ;

- Fig.3, représentant le schéma d'un exemple de réalisation du circuit selon la figure 1, et

- Fig.4, représentant une variante relative à une utilisation du circuit selon l'invention pour le balayage d'un tube cathodique.

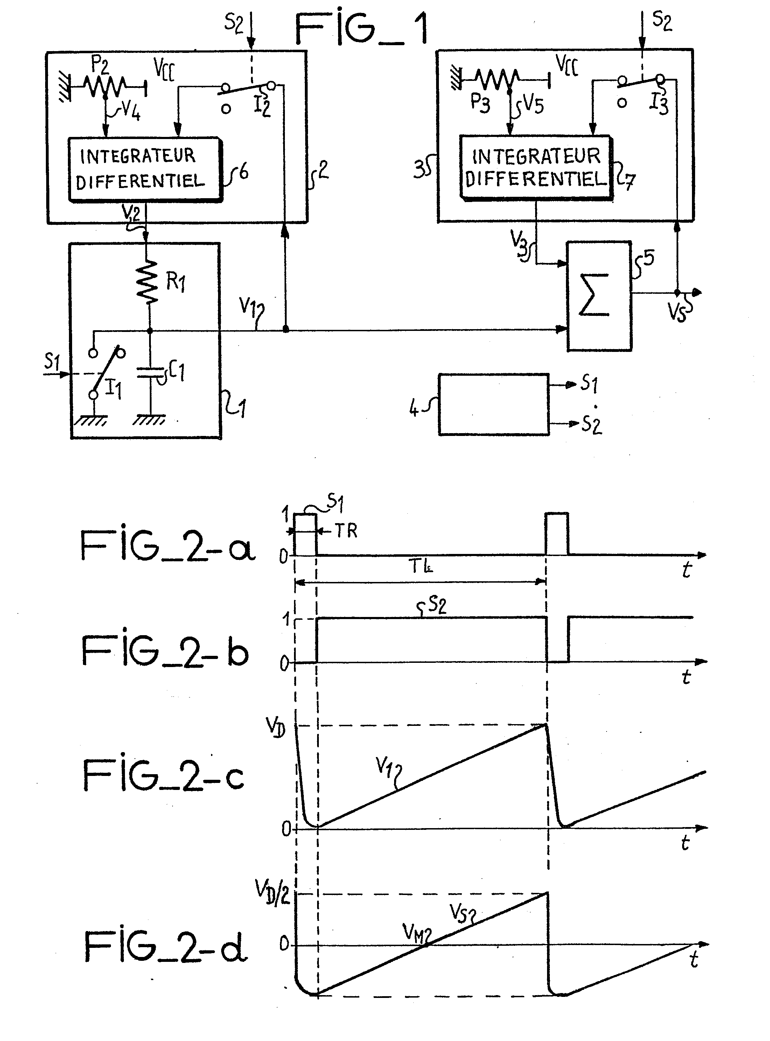

En se reportant à la figure 1, le circuit générateur de dents de scie comprend un circuit intégrateur 1. Celui-ci est constitué d'un interrupteur I1 commandant la décharge d'un condensateur C1 dont la première extrémité est connectée à un potentiel de référence et la deuxième extrémité reçoit à travers une résistance R1 le signal V2 issu d'un circuit générateur de signal à intégré 2. Ce circuit 2 comporte une alimentation continue stabilisée indiquée par Vcc et un moyen de réglage de l'amplitude symbolisé par le potentiomètre P2 pour faire varier Vcc et consécutivement l'amplitude de la dent de scie. Une deuxième entrée du circuit intégrateur 1 reçoit un train d'impulsions S1 (Fig.2A) délivré par un circuit générateur d'impulsions 4 pour commander la fermeture périodique de l'interrupteur I1. Le signal en dent de scie de sortie VS est appliqué à une première boucle d'asservissement comportant un interrupteur I3 d'entrée commandée par un signal S2 (Fig.2B) délivré par le circuit 4 en opposition par rapport à l'interrupteur I1 du circuit intégrateur, et un circuit intégrateur différentiel 7.

Selon l'invention, cette première boucle d'asservissement est associée à des moyens de réglage pour ajuster indépendamment le réglage du calage de la valeur moyenne des dents de scie VS. Ces moyens sont représentés également par une tension d'alimentation continue stabilisée Vcc ajustable par un potentiomètre P3 et constituent en combinaison avec la boucle d'asservissement (I3-6) un ensemble 3 générateur de signal de décalage V3 de la dent de scie. Le circuit générateur du signal à intégrer 2 comporte une deuxième boucle d'asservissement comprenant également un interrupteur I2 commandé par le signal S2, et un circuit intégrateur différentiel 6. Le signal en dents de scie V1 issu du circuit intégrateur 1 est appliqué à l'entrée de cette boucle qui agit sur l'amplitude de la dent de scie du signal V1 et à la première entrée d'un circuit sommateur 5.

La deuxième entrée du sommateur reçoit le signal de décalage V3. La sortie du sommateur 5 délivre le signal en dent de scie de sortie VS.

Le fonctionnement du circuit générateur de dents de scie est le suivant. L'interrupteur I1 est ouvert durant les intervalles TL-TR en dehors des impulsions S1 (Fig.2A) ce qui provoque la charge du condensateur C1 par le signal V2 à travers la résistance R1. Durant les impulsions S1, l'interrupteur se ferme et provoque la décharge instantanée du condensateur. Le signal en dents de scie résultant V1 varie du potentiel de référence, qui est nul de préférence (potentiel de masse), à une valeur VD déterminée fonction de la valeur de V2 et de la durée de charge TL-TR.

Les deux circuits générateurs 2 et 3, sont similaires et ont le même fonctionnement, on décrira l'un d'eux. L'interrupteur I2 du circuit générateur de signal à intégrer 2 transmet lorsqu'il est fermé la tension des dents de scie V1 au circuit intégrateur différentiel 6. La tension ajustable continue V4 délivrée par l'alimentation continue réglable Vcc-P2, constitue une tension de référence pour l'amplitude des dents de scies. L'intégrateur différentiel 6 délivre le signal V2 qui est fonction de la différence des deux tensions d'entrée V1 et V4. Si en cours de fonctionnement l'amplitude du signal de dents de scie V1 diminue, la différence entre les deux tensions V4 et V1 sur une période TL augmente et le signal V2 également. Le condensateur C1 du circuit intégrateur 1 se chargera avec un courant plus élevé et l'amplitude des dents de scie délivrées se réajustera progressivement à la valeur VD correspondant au réglage P2-V4. De même, si cette amplitude à tendance à augmenter, le signal V2 diminue et le condensateur C1 se charge moins rapidement. L'amplitude des dents de scie est ainsi régulée à la valeur VD désirée.

Dans le circuit générateur de signal de décalage V3 le même type d'asservissement est réalisé. La tension de référence V5 est ajustée en sorte que par action du signal V issu de ce générateur le signal en dents de scie V1 se décale pour obtenir la valeur moyenne VM calée sur la valeur désirée (centrage de dents de scie).

5

La figure 2A représente le signal S1 dont les impulsions provoquent la fermeture de l'interrupteur I1. La figure 2B représente le signal S2 dont les impulsions provoquent la fermeture des interrupteurs I2 et I3 des circuits générateurs 2 et 3. Le signal S1 peut correspondre au train d'impulsions retour ligne ou trame délivré pour une synchronisation télévision. La figure 2C représente le signal V1 issu du circuit intégrateur 1 et la figure 2D le signal de sortie VS dont la valeur moyenne VM a été choisie calée sur zéro.

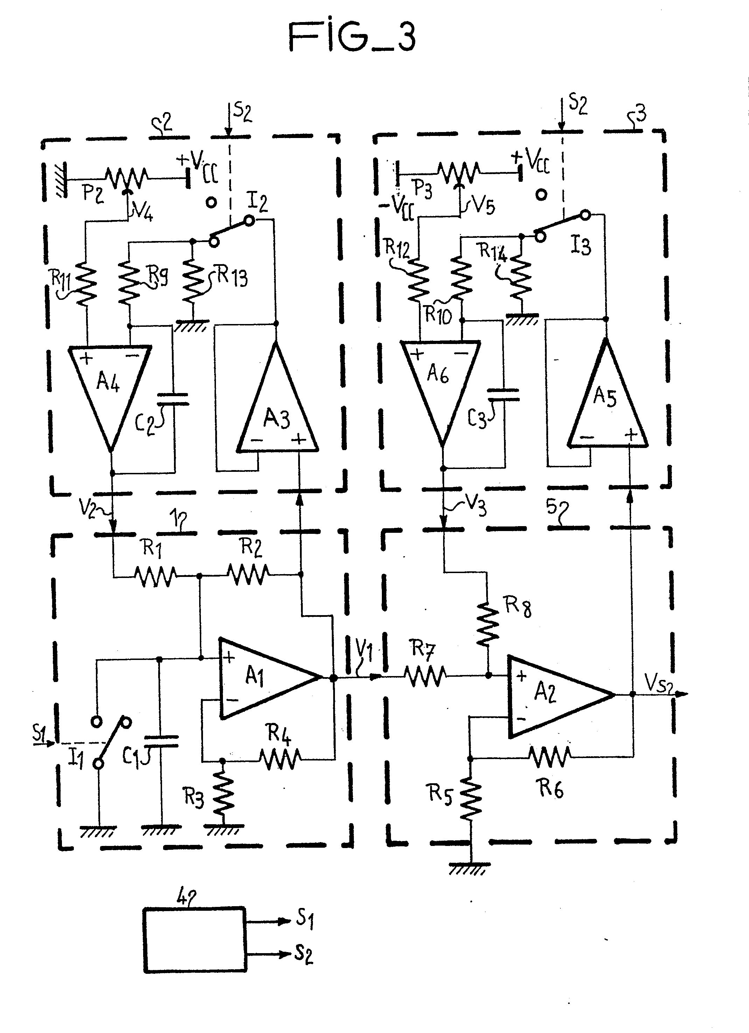

Dans l'exemple de réalisation décrit sur la figure 3 on peut remarquer l'utilisation de montages d'amplificateurs opérationnels de type connu. Le circuit intégrateur 1 utilise un amplificateur opérationnel A1 monté en amplificateur. L'entrée positive de A1 est connectée au condensateur C1 et par l'intermédiaire de la résistance R2 à la sortie de A1. L'entrée négative de A1 est connectée à sa sortie par la résistance R4 et à la masse par la résistance R3. Si les valeurs des résistances R1 à R4 sont égales deux à deux selon les relations R1 = R3, et R2 = R4, ce montage permet au condensateur C1 de se charger avec une linéarité élevée. Le sommateur 5 est réalisé au moyen d'un amplificateur opérationnel A2 monté en sommateur non inverseur avec les éléments résistifs R5 à R8. Les deux amplificateurs opérationnels A3 et A5 sont montés en suiveur de tension pour isoler les sorties V1 et VS respectives des boucles d'asservissement correspondantes. Les montages intégrateurs différentiels sont réalisés de manière connue chacun à l'aide d'un condensateur C2,C3 connecté entre une entrée et la sortie d'un amplificateur opérationnel A4,A6.

La réalisation décrite à l'aide de la figure 3 peut s'appliquer à un balayage d'un tube vidicon d'une caméra de télévision ou à un tube cathodique d'un moniteur de télévision. A titre indicatif pour un balayage ligne de période 64 μs le condensateur C1 a une capacité de 10nF, pour un balayage trame de période 20 ms, de 1 μF. Les éléments résistifs R5, R6, R7, R8 ont une résistance égale à 22 kΩ, les éléments R9, R10, R11, R12 à 1,1 MΩ, les éléments R13, R14 à 2,7 kΩ, les condensateurs C2, C3 ont une capacité de 1 μF.

Les amplificateurs opérationnels qui peuvent être des LF 412 ont un gain important (70 dB). Les amplificateurs A4 et A6 sont choisis pour que les montages intégrateurs différentiels qu'ils constituent avec les condensteurs C2 et C3 aient des constantes de temps très grandes par rapport à la période TL.

Malgré les conditions climatiques très sévères telles qu'une plage d'écarts de température de 100°C, les dispersions dues au vieillissement et aux fortes différences de température et concernant la stabilité du point milieu et de l'amplitude des déflexions du spot autour de ce point sont considérablement réduites.

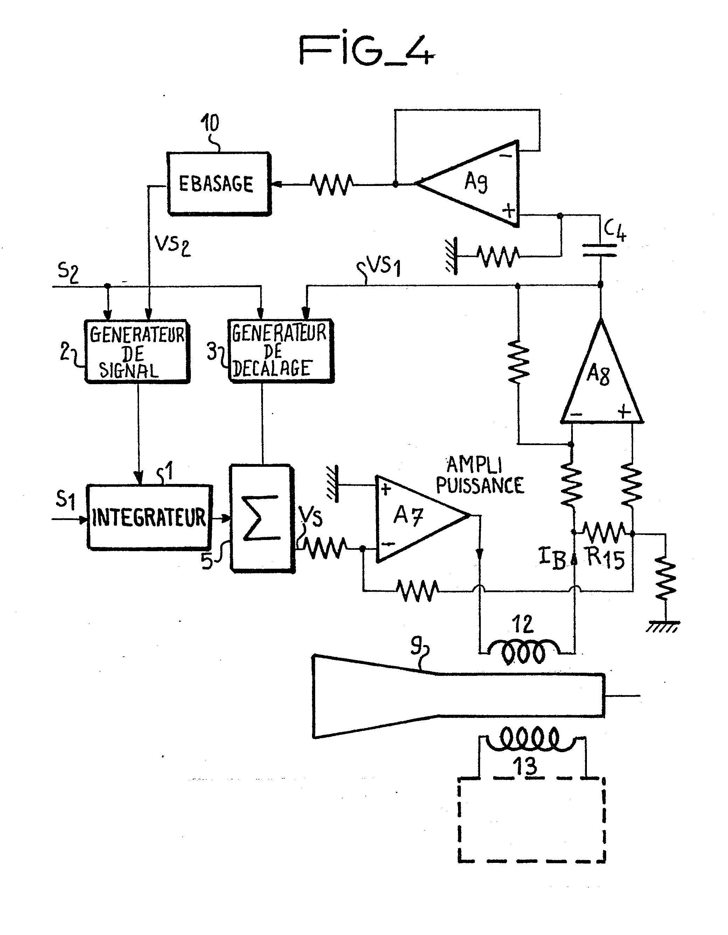

La variante illustrée par la figure 4 concerne une utilisation du circuit générateur selon l'invention pour délivrer un signal de balayage en dents de scie à un circuit de puissance alimentant des bobines de déviation électromagnétiques 12 et 13 d'un tube cathodique 9. Le signal de sortie VS appliqué précédemment à l'entrée du circuit générateur de signal de décalage 3 traverse un amplificateur de puissance A7 et une bobine 12. Une résistance R15 est placée en série avec la bobine 12 dans le but de mesurer aux bornes de cette résistance une tension proportionnelle au courant IB traversant la bobine 12. Ce signal est prélevé par l'amplificateur opérationnel A8 monté en amplificateur différentiel de tension et dont la sortie VS1 est transmise à la boucle de calage de la valeur moyenne dans le circuit générateur de décalage 3.

De même, le signal VS1 est appliqué de manière indirecte à la boucle de régulation d'amplitude dans le circuit générateur de signal à intégrer 2 à la place du signal V1. Le signal VS1 est appliqué à un condensateur C4 qui élimine la composante continue et qui est suivi d'un amplificateur opérationnel A9 monté en suiveur de tension, pour isoler les circuits de puissance A7 et d'utilisation 12 d'un circuit ébaseur 10 en aval. Ce dernier supprime du signal VS1 la partie dont la tension est inférieure au potentiel masse de référence de sorte que le signal VS2 qui est appliqué à l'entrée du circuit générateur 2 est aligné au même potentiel de référence que le signal V1 antérieur. La deuxième bobine 13 du tube cathodique 9 peut évidemment être alimentée par un deuxième montage semblable, le premier circuit assurant le balayage ligne dans la bobine 12, le deuxième assurant le balayage trame dans la bobine 13.

Grâce à ces aménagements les variations de l'amplitude et de valeur moyenne du signal en dents de scie, dues aux différences de température, et au vieillissement dans les amplificateurs de puissance et dans les bobines, sont prises en compte avant de régler et d'asservir le centrage et l'amplitude des dents de scie par rapport aux consignes de référence.

Bien qu'une seule variante ait été décrite dans une application à un balayage cathodique, d'autres variantes peuvent être réalisées par l'homme de l'art sans sortir du cadre de l'invention. Le circuit intégrateur 1 peut être remplacé par d'autres montages intégrateurs délivrant un signal dont la pente des dents de scie est constante et dont le potentiel le plus faible sera avantageusement calé au potentiel zéro. Dans l'exemple traité précédemment la pente des dents de scie est positive car la tension ajustable d'amplitude V4 est envisagée positive. Si le positionnement P2 est alimenté par une source continue négative -Vcc, cette tension V4 est négative et la pente des dents de scie l'est également. De plus le potentiomètre P3 sera avantageusement alimenté entre une source continue négative -Vcc et une source positive +Vcc, comme représenté sur la Fig. 3, en sorte que la tension ajustable de décalage V5 et consécutivement le signal de décalage V3, puissent varier positivement ou négativement de part et d'autre d'une valeur de centrage nulle.

0125947

8

## REVENDICATIONS

1. Circuit générateur de dents de scie comportant un intégrateur (1), un circuit générateur de signal à intégrer (2) pour alimenter l'intégrateur et qui est doté de moyens de réglage (P2) de l'amplitude des dents de scie du signal (V1) issu du circuit intégrateur à une valeur d'amplitude déterminée, un circuit générateur d'impulsions (4) pour la commande périodique de l'intégrateur, et une première boucle d'asservissement (I3-7) pour asservir la valeur moyenne des dents de scie à un potentiel de calage désiré, la première boucle recevant le signal de sortie en dents de scie (VS), caractérisé en ce que le circuit générateur de signal à intégrer (2) comporte une deuxième boucle d'asservissement (I2-6) pour asservir l'amplitude de la dent de scie à ladite valeur déterminée, la sortie du circuit intégrateur étant appliquée à l'entrée de la deuxième boucle ainsi qu'à une première entrée d'un circuit sommateur (5) qui reçoit par une deuxième entrée la sortie (V3) de la première boucle, le sommateur délivrant le signal de sortie en dents de scie (VS).

2. Circuit selon la revendication 1, caractérisé en ce qu'il comporte en outre des moyens de réglage (P3) de ladite valeur du potentiel de calage coopérant avec la première boucle d'asservissement pour modifier le calage de ladite valeur moyenne des dents de scie indépendamment de l'action sur l'amplitude produite par le circuit générateur de signal à intégrer (2).

3. Circuit selon la revendication 1 ou 2, dans lequel un premier interrupteur (I1) est monté en parallèle avec un condensateur (C1) dans un circuit intégrateur (1), un deuxième interrupteur (I3) est monté à l'entrée de la première boucle (I3-7), le circuit générateur d'impulsions (4) commandant en opposition ces interrupteurs (I2) et (I3), caractérisé en ce qu'un troisième interrupteur (I2) est placé à l'entrée de la deuxième boucle (I2-6) et est également commandé par le circuit générateur d'impulsions (4) en oppostion par rapport au premier interrupteur (I1)

4. Circuit selon les revendications 2 et 3, caractérisé en ce que lesdites deux boucles d'asservissement sont identiques et comportent chacune ledit deuxième et troisième interrupteur respectivement (I2,I3), suivi d'un montage intégrateur différentiel (6,7) pour délivrer les signaux à intégrer (V2) et de décalage (V3) en fonction des différences des signaux d'entrée des boucles (V1,VS) avec respectivement une tension de référence d'amplitude (V4) délivrée par les moyens de réglage (P2), et une tension de référence de calage (V5) délivrée par les moyens de réglage de la valeur moyenne (P3).

5. Circuit selon la revendication 1, caractérisé en ce que le condensateur (C1) et l'interrupteur (I1) sont chacun connectés par une première extrémité au potentiel de référence de masse, et par une deuxième extrémité à l'entrée positive d'un amplificateur opérationnel (A1) qui reçoit le signal à intégrer (V2) au travers d'une résistance (R1), une deuxième résistance (R2) relie l'entrée positive à la sortie de l'amplificateur (A1) une troisième résistance (R3) relie l'entrée négative au potentiel de référence, une quatrième résistance (R4) relie l'entrée négative à la sortie dudit amplificateur, les première et troisième résistances (R1 et R3) étant de même valeur, les deuxième et quatrième résistances (R2,R4) étant de même valeur.

6. Circuit selon la revendication 4, caractérisé en ce que les montages intégrateurs différentiels (6,7) sont réalisés chacun au moyen d'un amplificateur opérationnel (A4, A6), d'un condensateur (C2,C3) et de deux résistances (R9 et R11, R10 et R12), montés en intégrateurs différentiels.

7. Circuit selon l'une quelconque des revendications précédentes, caractérisé en ce que le sommateur (5) est constitué d'un amplificateur opérationnel (A2) monté en sommateur non inverseur recevant sur son entrée positive à travers une résistance (7) le signal (V1), issu de l'intégrateur (1), à travers une résistance R8 le signal (V3) de décalage, l'entrée négative étant connectée par une résistance R5 à la masse, et par une résistance R6 à la sortie.

8. Circuit selon la revendicaiton 4 ou 6, caractérisé en ce que sur l'entrée de chacune des boucles (12-6, 13-7) recevant les signaux en dents de scie (V1,VS), on place un amplificateur opérationnel (A3,A5) monté en suiveur de tension pour isoler les boucles des circuits en amont.

9. Variante de réalisation d'un circuit selon l'une quelconque des revendications précédentes et destiné à alimenter une bobine de déviation (12) électromagnétique d'un tube cathodique (9), caractérisée en ce que les boucles d'asservissement sont alimentées à partir d'un signal proportionnel au courant (IB) traversant la bobine, cette alimentation étant produite directement en ce qui concerne la boucle de calage de la valeur moyenne (13-7) et indirectement, par l'intermédiaire d'un condensateur (C4) suivit d'un amplificateur (A9) et d'un circuit ébaseur (10), en ce qui concerne la boucle de stabilisation de l'amplitude (12-6).

10. Circuit selon l'une quelconque des revendications précédentes, utilisé pour produire le balayage cathodique d'une caméra ou d'un moniteur de télévision.

FIG_1

FIG_2-a

FIG_2-b

FIG_2-c

FIG_2-d

# FIG_3

# FIG_4

Office européen
des brevets

**RAPPORT DE RECHERCHE EUROPEENNE**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| A | EP-A-0 011 533 (THOMSON-CSF) * Figures 1-3; page 5, ligne 11 - page 8, ligne 15 * | 1,3 | H 03 K 4/50 |
| A | US-A-3 577 007 (A.L. CROSS) * Figures 1-3; colonne 2, ligne 3 - colonne 3, ligne 66 * | 1,3,4 | |
| A | ELECTRONICS, vol. 42, no. 5, 3 mars 1969, page 97, New York, US; P.R. ADBY: "Sawtooth generator delivers constant peak voltage" * En entier * | 1 | |

DOMAINES TECHNIQUES
RECHERCHES (Int. Cl. ³)

H 03 K

Le présent rapport de recherche a été établi pour toutes les revendications

| Lieu de la recherche | Date d'achèvement de la recherche | Examinateur |
|---|---|---|
| LA HAYE | 17-07-1984 | GYSEN L.A.D. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503. 03.82